**Europäisches Patentamt**

**European Patent Office**

**Office européen des brevets**

(11) Veröffentlichungsnummer: **0 337 196**
**A1**

## (12) EUROPÄISCHE PATENTANMELDUNG

(21) Anmeldenummer: **89105568.3**

(22) Anmeldetag: **29.03.89**

(51) Int. Cl.⁴: **H03H 7/38 , G01N 24/04**

(30) Priorität: **11.04.88 DE 3811985**

(43) Veröffentlichungstag der Anmeldung:
**18.10.89 Patentblatt 89/42**

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Oppelt, Ralph, Dr.**
**Lindenweg 1**
**D-8525 Weiher(DE)**
Erfinder: **Vester, Markus**
**Pappelgasse 18**
**D-8520 Erlangen(DE)**

(54) **Anordnung zur Impedanztransformation.**

(57) Die Erfindung bezieht sich auf eine Anordnung zur Impedanztransformation mit mehreren Elementarübertragern in der Ausführungsform als Leitungsübertragern, insbesondere als Impedanzwandler für die Hochfrequenzantenne eines Kernspintomographen. Erfindungsgemäß ist auf der Primär-und/oder Sekundärseite der Elementarübertrager (14 bis 16) wenigstens eine Kombination einer Parallel- und Serienschaltung von Innenleiter und Schirm vorgesehen. Mit solchen Leitungsübertragern können nahezu beliebige Übersetzungsverhältnisse ausgebildet werden.

FIG 1

FIG 2

EP 0 337 196 A1

## Anordnung zur Impedanztransformation

Die Erfindung bezieht sich auf eine Anordnung zur Impedanztransformation mit mehreren Elementarübertragern in der Ausführung als Leitungsübertrager. Leitungsübertrager werden in der Hochfrequenztechnik beispielsweise zur breitbandigen Anpassung zweier im Verhältnis 1:2 gestufter Impedanzen, beispielsweise zur Anpassung zweier parallelgeschalteter 50Ω-Funkantennen an einen 50Ω-Sender, insbesondere zur Anpassung zweier Sende- und Empfangsantennensysteme eines Kernspintomographen an einen Sender bzw. einen Empfänger verwendet. Um ausreichende Bandbreite bei geringen Durchgangsverlusten zu erzielen, ist zur Impedanzanpassung eine Anordnung von Elementarübertragern vorgesehen.

Für den Bereich niederfrequenter Wechselströme geeignete Übertrager enthalten im allgemeinen einen Kern magnetischen Materials sowie eine Primär- und Sekundärwicklung mit jeweils wenigstens einigen Windungen. Der dadurch gebildete Vierpol soll Strom und Spannung in gewünschter Weise ändern, d.h. eine Impedanztransformation vornehmen. Solche Übertrager sind zur Impedanztransformation geeignet, solange die Länge des eine Wicklung bildenden Leiters klein ist gegen die Wellenlänge. Funkantennen sollen bekanntlich auch für sehr hohe Frequenzen elektromagnetische Energie, d.h. beliebige Signale, unverzerrt übertragen. Bei Breitbandübertragern werden deshalb beide Wicklungen so eng gekoppelt, daß sie Leitungen mit definiertem Wellenwiderstand und vernachlässigbarem Strahlungsverlust bilden. Mit Leitungsübertragern kann praktisch jedes rationale Übersetzungsverhältnis realisiert werden. Ein Übersetzungsverhältnis von 3:2 erhält man beispielsweise mit fünf Elementarübertragern mit einem Übersetzungsverhältnis von 1:1, von denen die ersten beiden auf der Primärseite parallel und sekundär in Reihe geschaltet werden. Damit erhält man ein Spannungsverhältnis von 1:2. Die drei weiteren Elementarübertrager werden auf der Primärseite in Reihe und sekundär parallelgeschaltet. Damit erhält man eine Spannungsübersetzung von 3:1 und somit eine Gesamtübersetzung von 3:2. Man benötigt aber für ein Übersetzungsverhältnis von beispielsweise M:N immer die Summe von N + M Übertragern (NTZ 1966, Heft 9, Seiten 527 bis 538)

Der Erfindung liegt die Aufgabe zugrunde, diese bekannte Ausführungsform einer Anordnung zur Impedanztransformation mit Leitungsübertragern zu vereinfachen.

Ein Impedanzwandler für ein Impedanzverhältnis 1:2 erfordert bekanntlich eine Spannungsübersetzung $\ddot{U} = 1 : \sqrt{2}$. In der Praxis genügt es im allgemeinen, dieses Übersetzungsverhältnis durch ein rationales Übersetzungsverhältnis anzunähern. Die verhältnismäßig gute Näherung $\ddot{U} = 5 : 7 = 1 : 1,4$ läßt sich zwar mit der bekannten Anordnung mit Elementarübertragern verwirklichen, erfordert jedoch einen Aufwand von mindestens zwölf Elementarübertragern.

Die Erfindung beruht nun auf der Erkenntnis, daß sich die einfache Näherung $\ddot{U} = 2 : 3 = 1 : 1,5$ im allgemeinen als ausreichend erweist. Daraus ergibt sich nämlich eine Impedanztransformation von $\ddot{U} = 1 : 2,25$ und somit ein theoretischer maximaler Reflexionsfaktorbetrag von $|r| = |(2,25-2)/(2,25+2)| \approx 0,059$. Daraus folgt $1-|r|^2 = 99,65\ \%$. Die übertragene Wirkleistung ist somit nur 0,35 % geringer als die eingespeiste Wirkleistung. Die Erfindung geht aus von dieser Erkenntnis und besteht jeweils in den kennzeichnenden Merkmalen der Ansprüche 1 und 2.

Eine Impedanztransformation von 2,25:1 mit einer Spannungsübersetzung von 1,5:1 erhält man beispielsweise mit drei Elementar übertragern, bei denen die ersten beiden Primärwicklungen parallelgeschaltet und diese beiden wicklungen mit der dritten Primärwicklung in Reihe geschaltet werden.

In einer vereinfachten Ausführungsform mit zwei Elementarübertragern können die Primärwicklungen parallel und die Sekundärwicklungen in Reihe geschaltet werden. Dann werden die Enden der Primärwicklung mit dem Anfang der ersten Sekundärwicklung verbunden.

Ferner können drei Elementarübertrager vorgesehen sein, deren erste Primärwicklung mit der parallelschaltung aus der zweiten und dritten Primärwicklung in Reihe geschaltet ist. Die erste Sekundärwicklung wird der Reihenschaltung aus der zweiten und dritten Sekundärwicklung parallelgeschaltet.

Diese Ausführungsform kann ebenfalls dadurch vereinfacht werden, daß zwei Elementarübertrager vorgesehen sind, die primärseitig in Reihe geschaltet sind und bei denen die Anfänge der beiden Sekundärwicklungen miteinander verbunden sind. In dieser Ausführungsform wird dann die Verbindung der beiden Primärwicklungen an das Ende der zweiten sekundärwicklung angeschlossen. Mit diesen Ausführungsformen erhält man mit geringem Aufwand einen Leitungsübertrager mit einer Impedanzwandlung von 3/2 $Z_0$ auf 2/3 $Z_0$ bzw. einer Spannungsübersetzung von 3/2 U auf U.

Die Leiter der einzelnen Elementarübertrager sind in diesen Ausführungsformen alle gleich lang und haben alle den gleichen Wellenwiderstand $Z_0$. Die Elementarübertrager werden gegebenenfalls durch induktive Beschwerung hochfrequenzmäßig entkoppelt. Mit gleicher Länge der Leiter der Elementarübertrager ergeben sich in den Ausführungsformen ohne Leitungsverbindungen zwischen der Primär- und Sekundärseite für alle Signalpfade gleiche Laufzeiten und somit für die Leitungsübertrager praktisch keine obere Grenzfrequenz.

Zur weiteren Erläuterung der Erfindung wird auf die Zeichnung Bezug genommen, in deren

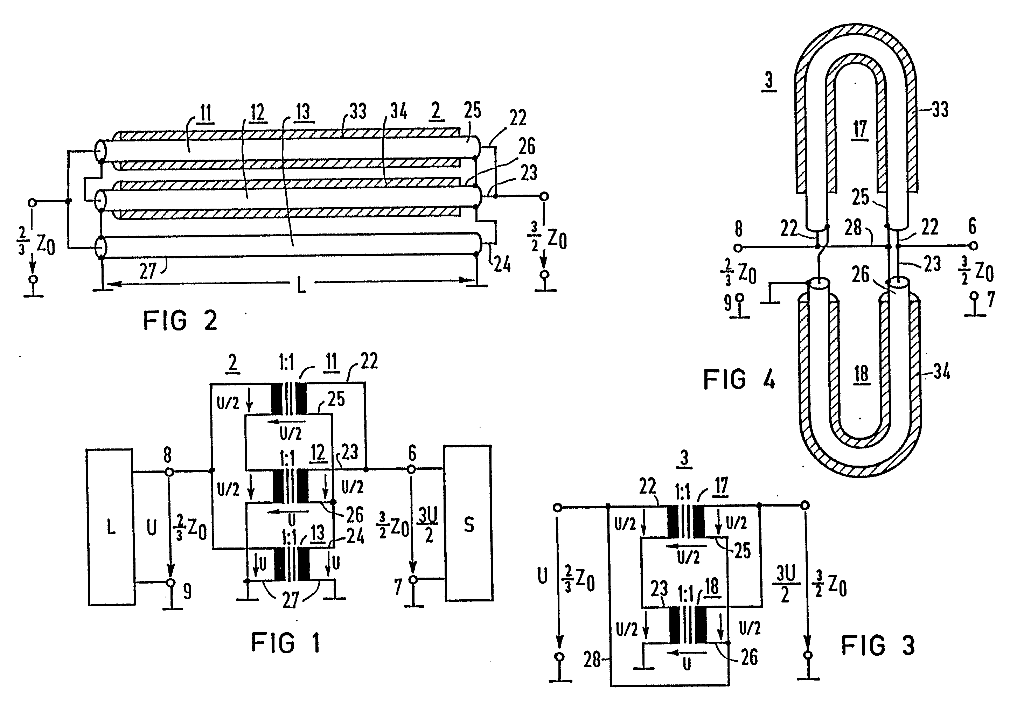

Figur 1 das niederfrequente Ersatzschaltbild eines Leitungsübertragers gemäß der Erfindung schematisch veranschaulicht ist.

Die praktische Ausführungsform dieses Übertragers ist in Figur 2 dargestellt.

In Figur 3 ist eine vereinfachte Ausführungsform als niederfrequentes Ersatzschaltbild und in Figur 4 die praktische Ausführungsform dieses Leitungsübertragers veranschaulicht.

In Figur 5 ist eine weitere Ausführungsform als niederfrequentes Ersatzschaltbild und in Figur 6 die praktische Ausführungsform hiervon dargestellt.

Figur 7 zeigt eine vereinfachte Ausführungsform der Figur 5 und Figur 8 die praktische Ausführungsform dieses Übertragers.

In der Ausführungsform einer Anordnung zur Impedanztransformation gemäß der Erfindung, die in Figur 1 zur Vereinfachung als niederfrequentes Ersatzschaltbild dargestellt ist, besteht ein Leitungsübertrager 2 aus drei Elementarübertragern 11, 12 und 13 jeweils mit einer Spannungsübersetzung 1:1. An die Eingangsklemmen 6 und 7 der Primärwicklung des Leitungsübertragers 2 ist ein Sender S mit einer Spannung von beispielsweise $3/2\ U = 500\ V$ angeschlossen. An die Ausgangsklemmen 8 und 9 ist beispielsweise eine Last L angeschlossen. Die Eingangsklemme 7 und die Ausgangsklemme 9 sind an Masse gelegt. Die Primärwicklungen der Elementarübertrager 11 und 12 liegen parallel und sind mit der Primärwicklung des Elementarübertragers 13 in Reihe geschaltet. Von den Primärwicklungen der Elementarübertrager 11 und 12 wird so mit die Spannung $U/2$ und von der Primärwicklung des Übertragers 13 wird die Spannung $U$ übertragen. Die Sekundärwicklungen der Übertrager 11 und 12 sind in Reihe geschaltet und diese Reihenschaltung ist der Sekundärwicklung des Übertragers 13 parallelgeschaltet. Auf der Sekundärseite wird somit von den Übertragern 11 und 12 jeweils $U/2$ und vom Übertrager 13 die Spannung $U$ übertragen, so daß die Gesamtspannung auf der Sekundärseite $U$ beträgt. Die Kabelimpedanz $Z_0$ der drei Elementarübertrager 11, 12 und 13 wird jeweils so groß gewählt, daß die Impedanz der Primärseite $Z \approx 3/2\ Z_0$ und die Impedanz der Sekundärseite $Z/2 \approx 2/3\ Z_0$ beträgt.

In der praktischen Ausführungsform des Leitungsübertragers 2 gemäß Figur 2 bestehen die drei Elementarübertrager 11, 12 und 13 jeweils aus einem Koaxialkabel. Die Innenleiter der Elementarübertrager 11, 12 und 13 sind mit 22 bzw. 23 bzw. 24 bezeichnet. Mit dem Schirm 27 liegt die Sekundärseite des Elementarübertragers 13 an Masse. Die Elementarübertrager 11 und 12 sind jeweils mit einer induktiven Beschwerung 33 bzw. 34 versehen, die vorzugsweise aus einem Mantel aus Ferrit bestehen kann und mit der man eine hohe Induktivität bei verhältnismäßig kurzer Leitungslänge $L$ erhält. Die Leitungslänge $L$ kann beispielsweise etwa 10 cm betragen.

Da alle Koaxialkabel der Elementarübertrager 11, 12 und 13 gleich lang sind, haben alle Signalpfade die gleichen Laufzeiten, so daß der Leitungsübertrager 2 theoretisch keine obere Grenzfrequenz besitzt. In der Praxis ergibt sich eine obere Grenzfrequenz im wesentlichen durch die Streuinduktivitäten und Streukapazitäten an den Leitungsenden sowie durch die Kapazitäten der erdfreien Schirme 25 und 26 gegen Masse. Eine untere Grenzfrequenz ist durch die endliche induktive Beschwerung 33 und 34 der Elementarübertrager 11 und 12 gegeben, da bei sinkender Frequenz die Bedingung, daß die induktive Entkoppelimpedanz $\omega L$ sehr viel größer sein muß als die Kabelimpedanz $Z_0$, nicht mehr erfüllt ist. Die drei Elementarübertrager 11, 12 und 13 mit jeweils der Impedanz $Z_0$ transformieren die Gesamtimpedanz $3/2\ Z_0$ der Senderseite auf die Impedanz $2/3\ Z_0$ der Empfängerseite. Das Impedanztransformationsverhältnis ist demnach $4:9 = 1:2,25$. In einem Leitungsübertrager gemäß den Figuren 1 und 2 zur Anpassung beispielsweise des Senders S mit einer Impedanz von 50Ω an eine hochfrequente Last L mit einer Impedanz von 25Ω können in einfacher Weise sogenannte Semi-Rigid-Leitungen verwendet werden. Die Last L kann beispielsweise aus zwei parallelgeschalteten 50 Ω-Lasten, insbesondere zwei parallelgeschalteten Funkantennen, bestehen.

In der Ausführungsform gemäß Figur 1 sind induktive Beschwerungen 33 und 34 jeweils aus einem Ferrit-Mantel vorgesehen. Unter Umständen kann es zweckmäßig sein, abweichend von der Ausführungsform gemäß Figur 2, jeweils eine induktive Beschwerung dadurch herzustellen, daß die Koaxialkabel der Elementarübertrager 11 und 12 jeweils zu einer oder mehreren Windungen aufgewickelt werden.

In einer vereinfachten Ausführungsform eines Leitungsübertragers 3 gemäß Figur 3 mit den Elementarübertragern 17 und 18 kann der Elementarübertrager 13 dadurch eingespart werden, daß zwischen dem Mantel 26 des Koaxialkabels des Elementarübertragers 18 und dem Innenleiter 22 des Elementarübertragers 17 eine Leitungsbrücke 28 hergestellt wird. In dieser Ausführungsform des Leitungsübertragers 3 mit gemäß Figur 1 parallelgeschalteten Primärwicklungen und in Reihe geschalteten Sekundärwicklungen wird ebenfalls mit einem übersetzungsverhältnis von 3/2 U : U = 1,5 : 1 die Impedanz 3/2 $Z_0$ des Senders auf eine Impedanz 2/3 $Z_0$ des Empfängers transformiert.

In der praktischen Ausführungsform des Leitungsübertragers 3 gemäß Figur 4 können vorzugsweise die Koaxialkabel der Leitungsübertrager 17 und 18 mit ihren Beschwerungen 33 und 34 U-förmig gebogen sein, damit die Leitungsanschlüsse der Primär- und Sekundärseite unmittelbar nebeneinander liegen und nur kurze Leitungsverbindungen erforderlich sind. Auf der Primärseite wird in beide Innenleiter 22 und 23 eingespeist. Die beiden Schirme 25 und 26 sind über die Leitungsbrücke 28 mit dem Innenleiter 22 und dem Ausgang 8 der Sekundärseite verbunden. Die direkte Leitungsbrücke 28 hat zwar ungleiche Laufzeiten von der Primär- zur Sekundärseite zur Folge, dieser geringe Phasenfehler macht sich jedoch erst bei sehr hohen Frequenzen von beispielsweise mehreren 100 MHz bemerkbar.

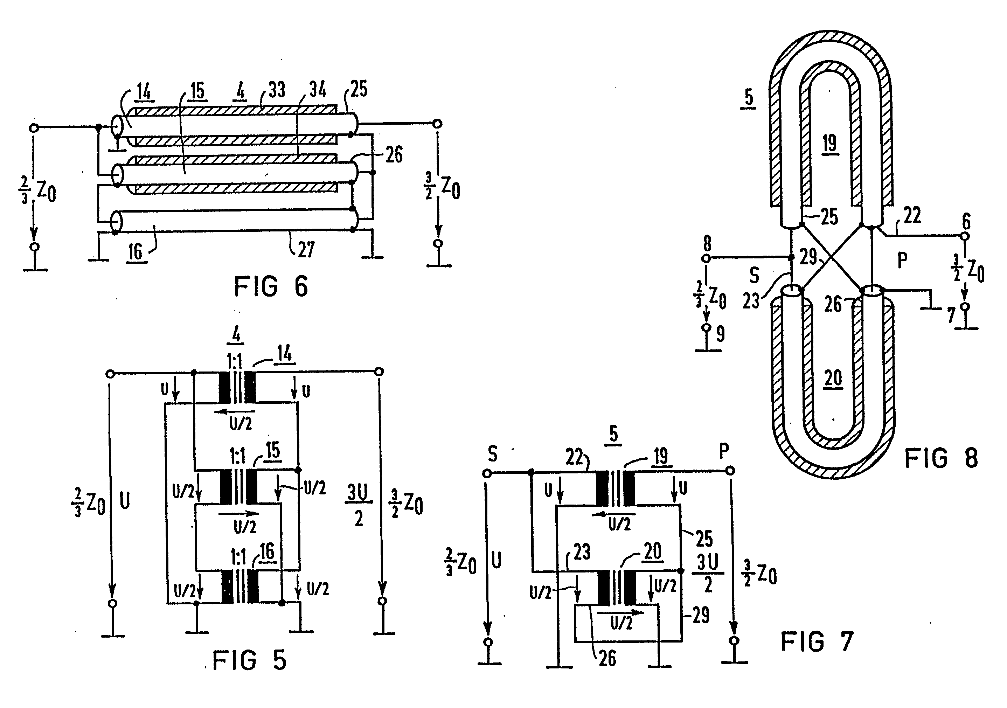

In der Anordnung zur Impedanztransformation gemäß Figur 5 mit einem Leitungsübertrager 4, der drei Elementarübertrager 14, 15 und 16 enthält, wird ebenfalls von der Primärseite eine Impedanz 3/2 $Z_0$ transformiert auf 2/3 $Z_0$ auf der Sekundärseite. Die Spannung 3/2 U auf der Senderseite wird umgewandelt in U auf der Sekundärseite. Die Primärwicklung des Elementarwandlers 14 ist in Reihe geschaltet mit der Parallelschaltung der Primärwicklungen der Elementarübertrager 15 und 16. Auf der Sekundärseite ist die Sekundärwicklung des Elementarübertragers 14 parallelgeschaltet zur Reihenschaltung der Sekundärwicklungen der Übertrager 15 und 16.

In der praktischen Ausführungsform des Leitungsübertragers 4 gemäß Figur 6 sind wieder die Schirme 25 und 26 der Elementarübertrager 14 und 15 jeweils mit einer induktiven Beschwerung 33 bzw. 34 versehen. Die Schirme 26 und 27 der Elementarübertrager 15 und 16 liegen primärseitig an Masse.

Wie in Figur 5 unterhalb der Elementarübertrager 14 und 15 durch Spannungspfeile angedeutet, fällt an den Außenleitern der beiden Koaxialkabel lediglich jeweils die Spannung U/2 ab. In dieser Ausführungsform wird deshalb mit den gleichen induktiven Beschwerungen 33 und 34 eine um den Faktor 2 tiefere untere Grenzfrequenz erreicht als bei den Ausführungsformen nach den Figuren 1 bis 4. Diese Ausführungsform des Leitungsübertragers 4 hat somit eine größere relative Bandbreite.

In der vereinfachten Ausführungsform eines Leitungsübertragers 5 gemäß Figur 7 zur Impedanztransformation von 3/2 $Z_0$ auf der Primärseite P zu 2/3 $Z_0$ auf der Sekundärseite S sind gemäß der Darstellung in Figur 7 als niederfrequentes Ersatzschaltbild zwei Elementarübertrager 19 und 20 vorgesehen. Die Primärwicklungen dieser Elementarübertrager 19 und 20 sind in Reihe geschaltet und die Anfänge der Sekundärwicklungen sind miteinander verbunden. Die Sekundärseite S des Elementarübertragers 20 ist über eine Leitungsbrücke 29 mit der Verbindung der beiden Primärwicklungen der Leitungsübertrager 19 und 20 verbunden. An den Schirmen 25 und 26 der entsprechenden Koaxialkabel der Elementarübertrager 19 und 20 fällt jeweils die Spannung U/2 ab, wie in der Figur 7 durch Pfeile angedeutet ist. Diese Ausführungsform hat somit ebenfalls eine größere relative Bandbreite.

In der praktischen Ausführungsform des Leitungsübertragers 5 gemäß Figur 8 sind die beiden Koaxialkabel der Elementarübertrager 19 und 20 jeweils U-förmig gebogen, so daß die Enden nahe beieinander liegen. Die Innenleiter 22 und 23 sind mit dem Ausgang 8 verbunden. Die Leitungsbrücke 29 verbindet den Schirm 26 des Elementarübertragers 20 mit dem Schirm 25 des Elementarübertragers 19. Der Schirm 26 liegt auf der Primärseite P an Masse. In dieser Ausführungsform transformiert der Leitungsübertrager 5 eine Impedanz 3/2 $Z_0$ auf der Primärseite P auf 2/3 $Z_0$ auf der Sekundärseite S, lediglich mit einer etwas verminderten oberen Grenzfrequenz, die jedoch bei sehr hoher Frequenz beispielsweise im Bereich von mehreren 100 MHz liegt.

In der Ausführungsform der Leitungsübertrager gemäß den Ausführungsbeispielen der Figuren 2, 4, 6 und 8 sind handelsübliche Koaxialkabel vorgesehen. Unter Umständen kann es zweckmäßig sein, anstelle der Koaxialkabel symmetrische Zweidrahtleitungen zu verwenden.

Es ist auch möglich, die Leitungsübertrager mittels symmetrischer Streifenleitungen ätztechnisch zu realisieren und gegebenenfalls auf die Verwendung eines Ferritmantels zur induktiven Beschwerung zu verzichten. Besteht ein Leitungsübertrager aus mehreren Elementarübertragern, so können Windungszahl, -orientierung und -anordnung der Leitungen der einzelnen Elementarübertrager so gewählt werden, daß sich die magnetischen Flüsse überlagern und dies die gewünschte Induktivitätswirkung wiederum verstärkt (NTZ 1966, Heft 9, S. 527 bis 538). Bei einem Leitungsübertrager nach Figur 7 fällt längs der Leitung der beiden Elementarübertrager 19 und 20 jeweils die gleiche Spannung U/2 ab. Werden diese Leitungen zur Überlagerung der magnetischen Flüsse dicht nebeneinander angeordnet, so müssen gleiche Windungszahlen gewählt werden.

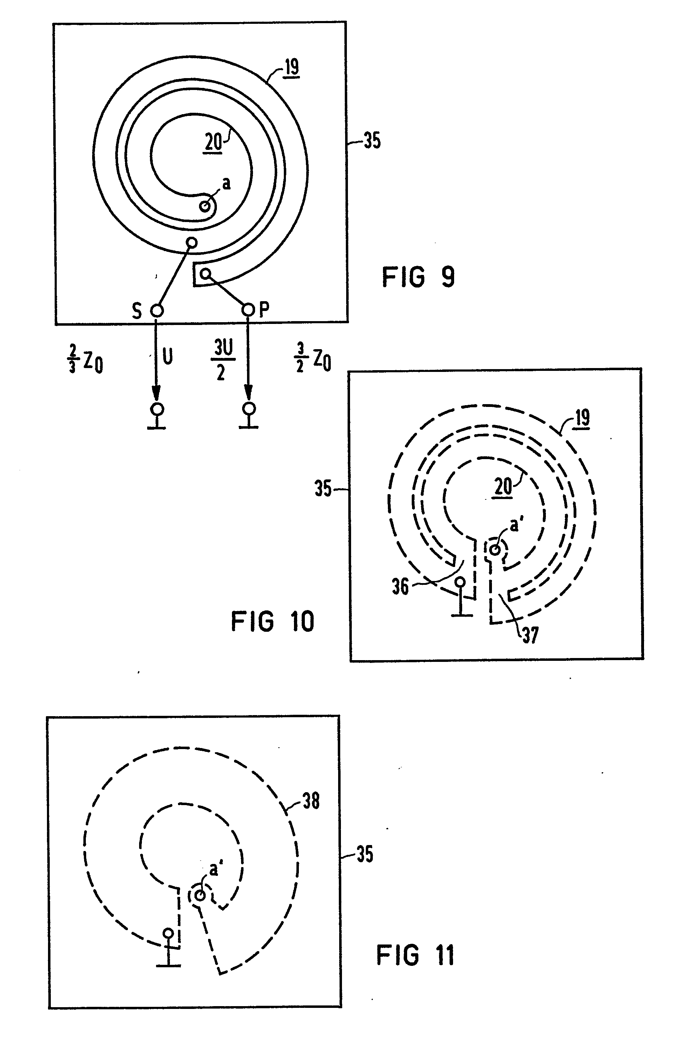

Eine besondere Ausführungsform des Leitungsübertragers besteht darin, daß mindestens eine Leitung der Leitungsübertrager 11 bis 20 als symmetrische Streifenleitung (strip line) ausgeführt wird. Beispielsweise ist eine Ausführungsform des in Figur 7 dargestellten Leitungsübertragers in Streifenleitungstechnik unter Berücksichtigung der vorerwähnten Flußüberlagerung anhand der Figuren 9 und 10 veranschaulicht. Hierbei ist gemäß Figur 9 eine Leiterbahnstruktur auf der Oberseite eines in der Figur angedeuteten, als Dielektrikum dienenden Substrats 35 angeordnet. Eine nahezu gleiche Leiterbahnstruktur gemäß Figur 10 ist auf der Unterseite des Substrats 35 derart angeordnet, daß sich deckungsgleiche Windungen der Spiralen ergeben. Diese auf der Unterseite angeordnete Leiterbahnstruktur ist gestrichelt dargestellt. Jeweils eine Windung der Leiterbahn auf der Ober- und Unterseite des Substrats 35 bilden einen Elementarübertrager aus einer symmetrischen Streifenleitung mit der Impedanz $Z_0$, so daß sich für die beiden Elementarübertrager 19 und 20 ein spiralförmiges Muster mit zwei Windungen ergibt. Der äußere Streifenleiter bildet dann den Elementarübertrager 19 und der innere Streifenleiter den Elementarübertrager 20 der Figur 7. Die Leiterbahnen auf der Oberseite entsprechen den Innenleitern 22 und 23 und die Leiterbahnen auf der Unterseite den Schirmen 25 und 26 der Koaxialkabel gemäß Figur 8. Die Verbindungen der einzelnen Leiterbahnanfänge und -enden auf Ober- und Unterseite, beispielsweise die Leiterbahnstege 36 und 37 sowie die Durchkontaktierung des Punktes a auf der Oberseite mit dem Punkt a' auf der Unterseite, ergeben sich aus Figur 8, so daß ein Leitungsübertrager mit dem Ersatzschaltbild der Figur 7 entsteht.

Ein herstellungstechnischer Vorteil dieser Ausführungsform als Streifenleiter gemäß den Figuren 9 und 10 besteht darin, daß für die Verbindungen keine Überbrückung einer Leiterbahn notwendig ist.

Ein weiterer Vorteil dieser Ausführungsform besteht darin, daß auf die primär- und sekundärseitigen Anschlußpunkte P und S zugegriffen werden kann, ohne daß damit eine Leiterbahn überbrückt werden muß. Dies ermöglicht eine induktivitätsarme Verbindung zu anderen, in der Figur nicht dargestellten Bauelementen. Der Leitungsübertrager kann beispielsweise ohne Leiterbrücken direkt in Hochfrequenzschaltungen mit üblichen unsymmetrischen Streifenleitungen integriert werden.

Ferner ist es möglich, zur Optimierung des Übertragungsverhaltens im Bereich der oberen Grenzfrequenz den sekundärseitigen Anschlußpunkt S an der Spirale auf der Oberseite etwas in Richtung zum Anschlußpunkt P zu verschieben. Zusammen mit den bekannten Netzwerken bestehend aus Längs- und Querkapazitäten zur Anpassungsverbesserung am Ein- und Ausgang läßt sich mit einer Anordnung gemäß den Figuren 9 und 10 auch ohne Beschwerung aus Ferrit-Material eine große Bandbreite von mindestens einer Dekade, beispielsweise von 20 bis 200 MHz, erreichen.

Wie die Figuren 9 und 10 zeigen, haben die auf der Unterseite befindlichen Leiterbahnen beider Elementarübertrager 19 und 20 aufgrund der Leiterbahnstege 36 und 37 längs des gesamten Windungsumfangs gleiches Potential. Deshalb können sie vorzugsweise längs des ganzen Windungsumfangs miteinander verbunden werden, so daß eine einzige, entsprechend breite Leiterbahn 38 auf der Unterseite verbleibt, wie es in Figur 11 dargestellt ist. Dies hat den Vorteil, daß die Kopplung der Streifenleitungen beider Elementarübertrager untereinander fester wird (close coupling) und somit die Induktivität der Windungen der Streifenleitungen weiter erhöht wird.

## Ansprüche

1. Anordnung zur Impedanztransformation mit mehreren Elementarübertragern in der Ausführung als Leitungsübertrager, **dadurch gekennzeichnet,** daß auf der Primär- und/oder Sekundärseite der Elementarübertrager (11 bis 16) wenigstens eine Kombination einer Parallel- und Serienschaltung von Innenleiter und Schirm (z.B. Parallelschaltung von 22, 25 mit 23, 26 in Serie zu 24, 27 auf der Primärseite, Figuren 1 und 2) derart vorgesehen ist, daß sich eine Impedanztransformation Ü = 1 : 2,25 ergibt.

2. Leitungsübertrager, insbesondere nach Anspruch 1, **dadurch gekennzeichnet,** daß wenigstens eine Leitungsbrücke (28, 29) zwischen der Primär- und der Sekundärseite verschiedener Elementarübertrager (17, 18; 19, 20) vorgesehen ist (Fig. 3 und 7).

3. Leitungsübertrager nach Anspruch 1, **dadurch gekennzeichnet,** daß drei Elementarübertrager (11 bis 13) mit dem Übersetzungsverhältnis 1:1 vorgesehen sind, bei denen die Primärwicklungen des ersten und zweiten Elementarübertragers (11, 12) parallel und zur Primärwicklung des dritten Elementarübertragers (13) in Reihe geschaltet sind und daß die Sekundärwicklungen des ersten und zweiten Übertragers (11, 12) in Reihe und der Sekundärwicklung des dritten Übertragers (13) parallelgeschaltet sind (Figuren 1 und 2).

4. Leitungsübertrager nach Anspruch 2, **dadurch gekennzeichnet,** daß zwei Elementarübertrager (17, 18) mit einem übersetzungsverhältnis von 1:1 vorgesehen sind, die jeweils als Koaxialkabel ausgeführt sind und bei denen jeweils der Mantel mit einer induktiven Beschwerung (33, 34) versehen ist, bei denen die Primärwicklungen parallel und die Sekundärwicklungen in Reihe geschaltet sind und bei denen die Mäntel (25 und 26) primärseitig miteinander verbunden und durch eine Leitungsbrücke (28) an den Innenleiter (22) auf der Sekundärseite des ersten Elementarübertragers (17) angeschlossen sind (Figuren 3 und 4).

5. Leitungsübertrager nach Anspruch 1, **dadurch gekennzeichnet,** daß drei Elementarübertrager (14 bis 16) vorgesehen sind, bei denen die Primärwicklung des ersten Übertragers (14) mit der Parallelschaltung der Primärwicklungen des zweiten und dritten Übertragers (15, 16) in Reihe geschaltet ist und bei denen die Sekundärwicklung des ersten Übertragers (14) der Reihenschaltung der Sekundärwicklungen des zweiten und dritten Übertragers (15, 16) parallelgeschaltet ist (Figuren 5 und 6).

6. Leitungsübertrager nach Anspruch 2, **dadurch gekennzeichnet,** daß zwei Elementarübertrager (19, 24) vorgesehen sind, deren Primärwicklungen in Reihe und deren Anfänge der Sekundärwicklungen miteinander verbunden sind und bei denen primärseitig eine Leitungsverbindung zwischen dem Mantel (25) des ersten Elementarübertragers (19) und dem Innenleiter (23) des zweiten Elementarübertragers (20) vorgesehen ist, die über eine Leitungsbrücke (29) mit dem Mantel (26) der Sekundärseite des zweiten Leitungsübertragers (20) verbunden ist, der auf der Primärseite an Masse liegt (Figuren 7 und 8).

7. Leitungsübertrager nach einem der Ansprüche 1 bis 6, **dadurch gekennzeichnet,** daß mindestens eine Leitung der Leitungsübertrager als symmetrischer Zweidrahtleiter ausgeführt ist.

8. Leitungsübertrager nach Anspruch 1, **dadurch gekennzeichnet,** daß mindestens eine Leitung der Leitungsübertrager (11 bis 20) als symmetrische Streifenleitung ausgeführt ist.

9. Leitungsübertrager nach Anspruch 6, **dadurch gekennzeichnet,** daß die Elementarübertrager (19, 20) jeweils aus einer symmetrischen Streifenleitung bestehen, deren deckungsgleiche Leiterbahnen auf den beiden Flachseiten eines Substrats (35) einander gegenüber angeordnet sind (Figuren 9 und 10).

10. Leitungsübertrager nach Anspruch 9, **dadurch gekennzeichnet,** daß die an einer der beiden Flachseiten des Substrats (35) angeordneten Leiterbahnen mit gleichem Potential längs des gesamten Windungsumfangs zu einer gemeinsamen Leiterbahn (38) miteinander verbunden sind (Figur 11).

88 P 8534 E

FIG 1

FIG 2

FIG 3

FIG 4

88 P 8534 E

FIG 8

FIG 7

FIG 6

FIG 5

FIG 9

$\frac{2}{3} Z_0$    U    $\frac{3U}{2}$    $\frac{3}{2} Z_0$

FIG 10

FIG 11

| Europäisches Patentamt | EUROPÄISCHER RECHERCHENBERICHT | Nummer der Anmeldung |
|---|---|---|
| | | EP 89 10 5568 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 129 464  (THOMSON-CSF) * Seite 6, Zeile 8 - Seite 7, Zeile 26; Figuren 4-6 * | 1-3,5 | H 03 H   7/38 G 01 N   24/04 |
| A | | 4,6 | |
| A | GB-A-1 599 557  (ENDRESS & HAUSER GmbH) * Seite 1, Zeilen 12-33; Seite 1, Zeile 83 - Seite 2, Zeile 43; Figuren 3,8 * & DE-A-2 744 862 | 1,3 | |
| A | US-A-3 428 886  (M. KAWASHIMA et al.) * Spalte 6, Zeile 40 - Spalte 8, Zeile 5; Figuren 6a,8a,8b * & DE-A-17 91 231 | 1,3,4 | |
| A | US-A-3 370 257  (H.C. SPIERLING) * Spalte 1, Zeilen 12-40; Figuren 1,2 * | 1,3,4 | |
| A | US-A-4 095 168  (L.F. HLAVKA) * Spalte 1, Zeile 42 - Spalte 2, Zeile 21; Spalte 5, Zeilen 11-61; Figuren 5-7 * & DE-A-2 806 447 | 1 | |
| A | NTZ, Band 19, Nr. 9, 1966, Seiten 527-538, Berlin, DE; W. HILBERG: "Einige grundsätzliche Betrachtungen zu Breitband-Übertragern" * Absatz III; Figuren 10,12,14,15 * | 1 | RECHERCHIERTE SACHGEBIETE (Int. Cl.4) G 01 N G 01 R H 01 F H 03 H |

Der vorliegende Recherchenbericht wurde für alle Patentansprüche erstellt

| Recherchenort | Abschlußdatum der Recherche | Prüfer |
|---|---|---|
| DEN HAAG | 03-07-1989 | HORAK G.I. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes Dokument

EPO FORM 1503 03.82 (P0403)